# FASCICULE DE BREVET EUROPEEN

(11) **EP 0 391 786 B1**
(45) Date de publication et mention de la délivrance du brevet: **22.03.1995**
(21) Numéro de dépôt: 90400903.2
(22) Date de dépôt: 03.04.1990
(51) Int. Cl.: H03G 1/04

(54) **Circuit d'amplification à gain commandé de manière linéaire**
Verstärkungsschaltung mit linearer Steuerung der Verstärkung
Amplification circuit with linear gain control

(30) Priorité: 04.04.1989 FR 8904406
(43) Date de publication de la demande: 10.10.1990
(73) Titulaire: THOMSON-CSF SEMICONDUCTEURS SPECIFIQUES, 92800 Puteaux (FR)
(72) Inventeur: Debroux, Jean-François, F-92045 Paris la Défense (FR)
(74) Mandataire: Guérin, Michel

(56) Documents cités:
- EP-A- 0 251 530
- EP-A- 0 272 702
- US-A- 4 523 153
- US-A- 4 736 166

## Description

L'invention concerne un circuit d'amplification électrique de signaux, et plus particulièrement un circuit d'amplification dont le gain peut être commandé à volonté par une grandeur électrique (courant ou tension).

On sait réaliser des amplificateurs dont le gain est commandé par un courant ou une tension. Par exemple, dans n'importe quel amplificateur à transistors, si on fait varier la résistance de charge d'un transistor de sortie, on obtient une variation de gain. Par conséquent, si on utilise comme charge un transistor ou un transistor en série avec une résistance, on peut réaliser une résistance de charge variable, commandée par un signal électrique attaquant la base du transistor. On obtient donc un gain variable commandé par la base de ce transistor de charge.

Le gain variable peut être obtenu aussi en agissant sur le courant de repos de l'amplificateur ou sur la valeur de la fraction du courant appliqué à la charge.

Le problème de ces amplificateurs à gain commandé est l'absence de linéarité entre le signal de commande de gain et le gain obtenu. Le gain n'est pas proportionnel à la tension ou au courant qui sert à faire varier le gain. Dans certaines applications, cela est gênant.

Pour rendre le gain proportionnel au signal qui le commande, on est amené généralement à intercaler, entre le signal de commande de gain et l'entrée de commande de gain de l'amplificateur, un circuit de correction qui compense la non-linéarité de la commande. Mais évidemment la linéarité globale obtenue est fonction de la qualité de la compensation sur toute la plage d'utilisation, et on comprend qu'il soit difficile de compenser exactement la non-linéarité de l'amplificateur.

De plus, il faut tenir compte des dispersions de fabrication: même si on arrivait théoriquement à adapter parfaitement un circuit de correction à l'amplificateur dont la commande de gain est à linéariser, la fabrication en série de l'amplificateur aboutirait fatalement à des dispersions de sorte que la correction de linéarité serait imparfaite dans la réalité. En particulier, dans une fabrication en circuits intégrés monolithiques, la dispersion de fabrication peut être importante.

Un exemple d'application importante pour laquelle s'est fait sentir le besoin d'un amplificateur à commande de gain précise et linéaire est la suivante : on désire réaliser un amplificateur dont le gain est directement proportionnel à la température absolue (par exemple pour réaliser l'étage d'entrée d'un amplificateur à gain logarithmique). Mais pour obtenir une précision suffisante tout en ayant un gain suffisant, on a été amené à réaliser en fait un circuit utilisant des résistances dont le coefficient de température est connu. Malheureusement, ces résistances ne peuvent être intégrées sur un circuit monolithique, ce qui est un inconvénient important.

Par conséquent, le besoin se fait sentir d'un circuit d'amplification à gain commandé, linéaire en fonction du signal de commande de gain et intégrable sur un circuit monolithique.

La présente invention a pour objet de proposer un tel circuit d'amplification à gain commandé.

Selon l'invention, on propose par conséquent un circuit d'amplification selon la revendication 1 qui a pour particularité de comporter deux amplificateurs à gain commandé identiques ; l'un reçoit le signal à amplifier et fournit un signal de sortie amplifié ; l'autre reçoit une tension ou un courant de référence et fournit une sortie qui est comparée à un signal de consigne de variation de gain. Le résultat de la comparaison sert à asservir le gain du deuxième amplificateur pour ajuster sa sortie à une valeur désirée. Le premier amplificateur reçoit le même signal de commande de variation de gain que le deuxième.

Par conséquent, le premier amplificateur (celui qui sert à amplifier un signal d'entrée à amplifier) a son gain asservi sur le gain du deuxième. Et le deuxième a sa sortie asservie sur une valeur de consigne tout en ayant comme signal d'entrée une tension ou un courant fixe. Il a donc un gain connu et proportionnel à la valeur de consigne. Finalement, le premier amplificateur, identique au deuxième et recevant le même signal de commande de gain a donc un gain proportionnel à la valeur de consigne, ce que l'on souhaitait.

Par conséquent, en pratique, le signal de commande de gain des deux amplificateurs à gain commandé est issu de la sortie d'un amplificateur différentiel ayant une entrée reliée à une entrée de tension ou courant de consigne et une autre entrée reliée à la sortie du deuxième amplificateur à gain commandé.

Dans une fabrication de circuits monolithiques intégrés, la dispersion de fabrication peut être important, mais on sait que sur un même circuit il est facile de faire avec une dispersion très faible deux amplificateurs identiques.

Le signal de consigne peut être un courant ou une tension et on adaptera facilement le circuit selon l'invention en fonction du choix effectué.

En résumé, l'invention propose un circuit d'amplification à gain commandé par un signal électrique de consigne, qui comporte deux amplificateurs à gain commandé identiques (A1 et A2), le premier (A1) ayant son gain asservi sur le gain du second (A2) et le second ayant sa sortie asservie sur le signal de consigne de gain (Vc) tout en ayant comme signal d'entrée une tension ou un courant fixe (Vref).

D'autres caractéristiques et avantages de l'invention apparaîtront à la lecture de la description détaillée qui suit et qui est faite en référence aux dessins annexés dans lesquels :
- la figure 1 représente un schéma de principe de l'invention ;
- la figure 2 représente un schéma correspondant dans lequel les signaux sont traités en différentiel ;
- la figure 3 représente une adaptation du schéma de la figure 2 avec une consigne fournie sous forme d'un courant ;
- la figure 4 représente un exemple de schéma de réalisation détaillée correspondant à la figure 3.

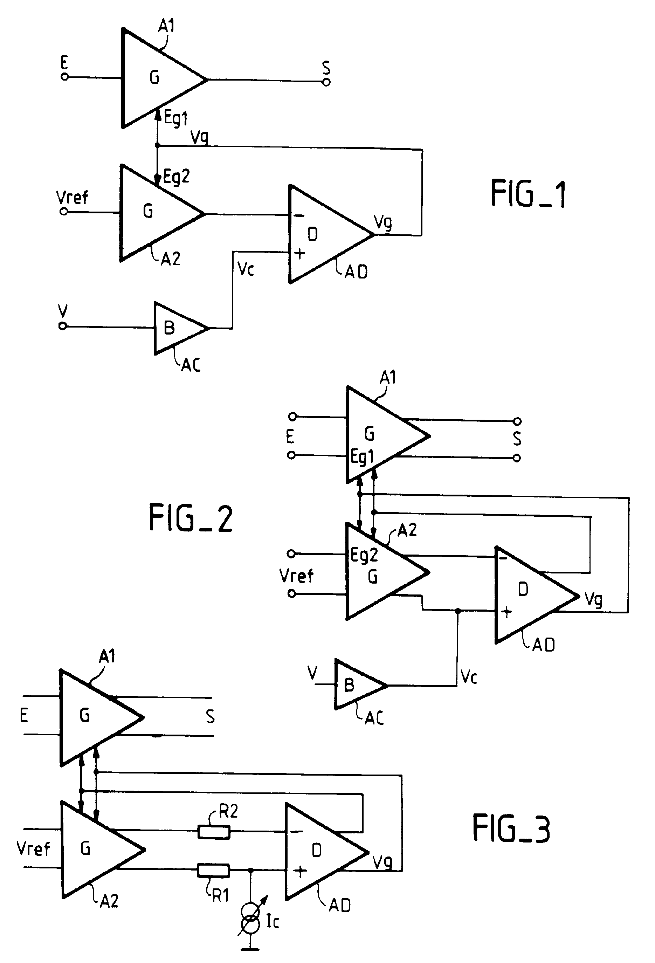

Sur la figure 1 on voit le circuit de base selon l'invention. Il comprend un amplificateur A1 à gain commandé. Cet amplificateur reçoit sur une entrée de signal à amplifier (E) un signal à amplifier. Il possède une entrée de commande de gain (Eg1), et son gain G est fonction du signal présent sur l'entrée Eg1. Il fournit sur sa sortie (S) un signal qui est le signal d'entrée multiplié par le gain G.

Dans ce qui suit on désignera en général par la même référence à la fois une entrée ou sortie et le signal présent sur cette entrée ou sortie.

Ainsi, la sortie de l'amplificateur A1 fournit un signal S=G.E. Le gain G varie en fonction du signal de commande de gain Vg présent sur l'entrée Eg1, mais cette variation est non linéaire. On peut écrire G=f(Vg), la fonction f étant non linéaire.

Le circuit comporte un deuxième amplificateur à gain commandé A2, identique au premier et recevant sur son entrée de commande de gain Eg2 le même signal de commande de gain Vg que l'amplificateur A1. Les amplificateurs A1 et A2 sont réalisés sur le même substrat de circuit-intégré.

L'entrée de signal du deuxième amplificateur est une valeur de référence, ici une tension de référence fixe Vref. Par conséquent, on peut écrire que la tension de sortie du deuxième amplificateur est VS2=G.Vref, le gain G à un instant donné étant le même que le gain G de l'amplificateur A1.

La sortie du deuxième amplificateur A2 est appliquée à une entrée d'un amplificateur différentiel AD de gain élevé qui possède une autre entrée recevant un signal de consigne de valeur de gain (signal Vc). Le rôle de cet amplificateur différentiel est de comparer la sortie du deuxième amplificateur et le signal de consigne, et de fournir un signal de commande de gain fonction de l'écart entre les signaux comparés. Ce signal est appliqué à l'entrée de commande de gain de l'amplificateur A2 (et par conséquent aussi à l'entrée de commande de l'amplificateur A1).

L'amplificateur différentiel AD a un gain D élevé et le sens de connexion des entrées différentielles est tel que l'asservissement ainsi réalisé tende à minimiser l'écart entre les deux entrées de l'amplificateur différentiel. Autrement dit, si l'on modifie le signal de consigne de valeur de gain Vc, l'amplificateur différentiel AD tendra à modifier en conséquence le gain de l'amplificateur A2 pour amener la sortie VS2 de A2 à une valeur aussi proche que possible du signal de consigne Vc. Le gain de l'amplificateur A1 suivra parallèlement les mêmes variations.

Comme dans tous les asservissements, il subsistera naturellement une tension d'erreur e=VS2-Vc entre les entrées de l'amplificateur différentiel. On s'arrangera pour minimiser cette tension d'erreur en augmentant le gain D de l'amplificateur différentiel, en tenant compte cependant de la bande passante de celui-ci pour ne pas introduire de risque d'oscillation de la boucle (ce problème est classique dans tous les asservissements).

Dans le cas théorique où le gain D est très grand, le gain G des amplificateurs A1 et A2 est égal à VS2/Vref, donc à Vc/Vref. Il est parfaitement linéaire par rapport au signal de consigne Vc, et ceci indépendamment du fait qu'il soit linéaire ou non en fonction de la tension de commande de gain Vg appliquée sur les entrées de commande de gain.

En pratique, il est facile de calculer le gain G des amplificateurs A1 et A2 dans le cas non-idéal où le gain D de l'amplificateur différentiel ne peut pas être considéré comme quasi-infini. Cela donne les limites d'utilisation du circuit selon l'invention. On aurait G=Vc/(Vref+1/D.K(Vg)) si G=K(Vg).Vg, c'est-à-dire si K(Vg) est une représentation de la non-linéarité du gain G en fonction de Vg.

On voit bien sur l'expression du gain G en fonction de Vc que l'on obtient une fonction d'autant plus linéaire que le gain G est grand, et plus précisément grand devant le produit K(Vg).Vref; ce produit représente en fait le rapport entre la tension de sortie de l'amplificateur A1 ou A2 et la tension Vg appliquée à son entrée de commande de gain. Il sera en général facile de respecter cette condition pour obtenir alors une commande de gain linéaire avec une très bonne approximation.

Si on veut pouvoir ajuster finement la pente de variation du gain G en fonction du signal de consigne Vc, on pourra utiliser un amplificateur supplémentaire (ou un atténuateur) AC pour produire le signal Vc. L'amplificateur supplémentaire pourra avoir un gain réglable à l'aide d'un rapport de résistances. Il n'y aura pas de problème de stabilité compte-tenu de ce que le signal de consigne est un signal de commande à bande passante beaucoup plus faible que le signal à amplifier E.

Le signal de commande de gain du circuit devient alors un signal V appliqué à l'amplificateur ou atténuateur AC de gain B pour produire un signal de consigne Vc=B.V.

A la figure 2, on a représenté un circuit similaire à celui de la figure 1 mais faisant appel à des amplificateurs A1 et A2 différentiels (entrées différentielles et sorties différentielles), sans changer le principe de fonctionnement du circuit. Les deux sorties différentielles de l'amplificateur A2 attaquent les entrées différentielles de l'amplificateur AD, l'une de ces entrées étant portée à un potentiel de consigne Vc (par exemple par l'amplificateur ou atténuateur AC).

A la figure 3, on a représenté un circuit similaire à celui de la figure 2, mais dans lequel le signal de consigne est un courant Ic plutôt qu'une tension. On a donc prévu une résistance R1 insérée entre une des deux sorties différentielles de l'amplificateur A2 et une entrée correspondante de l'amplificateur différentiel AD. Cette entrée reçoit le courant de commande Ic qui produit une chute de tension R1.Ic dans la résistance. L'autre sortie différentielle de l'amplificateur A2 est reliée, également à travers une résistance R2 égale à R1, à la deuxième entrée de l'amplificateur différentiel AD. La résistance R2 a pour fonction de compenser une chute de tension qui pourrait être due dans la résistance R1 non pas au courant Ic mais à un courant d'entrée consommé par l'amplificateur AD (en supposant qu'alors les courants consommés sont les mêmes sur les deux entrées de l'amplificateur AD, ce qui est vrai en régime d'équilibre dans les constructions usuelles d'amplificateurs différentiels).

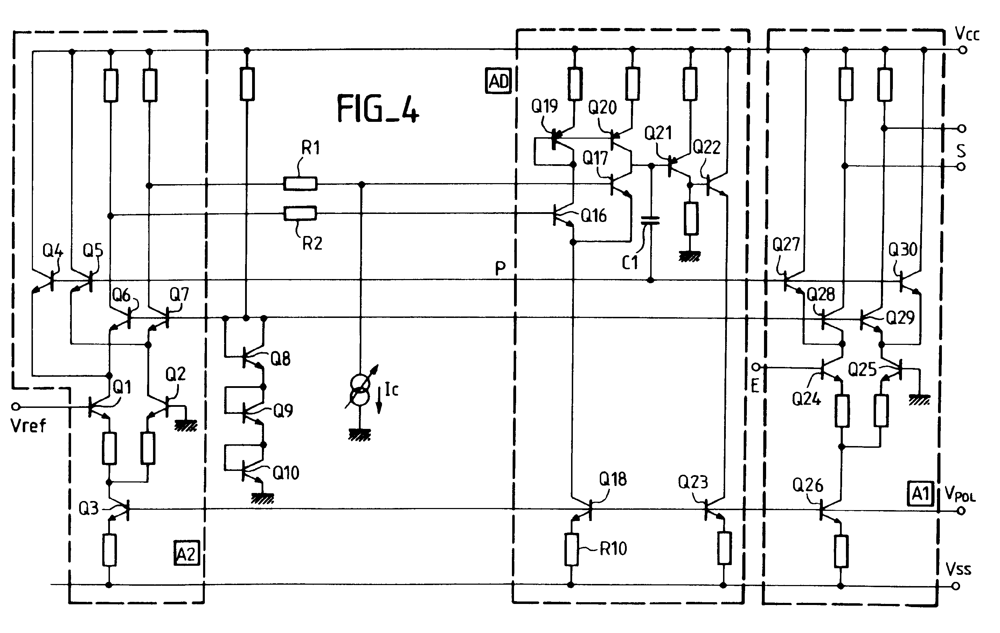

La figure 4 représente un exemple détaillé de réalisation de l'invention, cet exemple correspondant précisément au schéma de la figure 3. Les éléments de circuit correspondant aux éléments de la figure 3 ont été indiqués par des références correspondantes sur la figure 4.

Les amplificateurs A1 et A2 sont des amplificateurs différentiels de constitution très classique avec deux transistors. Une des entrées de chaque amplificateur est mise à la masse. L'autre entrée reçoit une tension (signal d'entrée à amplifier E pour A1, tension de référence Vref pour A2). Les sorties sont utilisées en mode différentiel. La sortie différentielle S de l'amplificateur A1 est la sortie du circuit selon l'invention. La sortie différentielle de l'amplificateur A2 attaque, à travers deux résistances R1 et R2 comme à la figure 3, l'entrée différentielle de l'amplificateur différentiel AD.

L'amplificateur AD est aussi un étage différentiel classique à grand gain et grande impédance d'entrée. Il possède de préférence une contre-réaction capacitive par effet Miller (capacité C1) pour limiter les risques d'oscillation dus au grand gain de l'amplificateur.

La consigne de gain du circuit est donnée par une source de courant variable IC, reliée à une entrée de l'amplificateur différentiel AD.

La sortie de l'amplificateur différentiel AD n'est pas prise en différentiel dans cet exemple. C'est une sortie simple P. Elle attaque la base de transistors situés dans les branches différentielles des amplificateurs A1 et A2. Pour l'amplificateur A1 deux transistors (Q27 et Q30) ont ainsi leur base commandée par la sortie de l'amplificateur différentiel AD. Ces transistors sont connectés chacun en parallèle sur une charge d'une des deux branches différentielles de A1. Cette charge est constituée par un transistor (Q28 pour une branche; Q29 pour l'autre) en série avec une résistance. Pour l'amplificateur A2, le montage est le même : il a deux branches différentielles dont les charges sont constituées par un transistor (Q6 pour la première branche, Q7 pour la deuxième) en série avec une résistance respective; et la sortie P de l'amplificateur AD attaque la base d'un transistor Q4 en parallèle avec la charge de la première branche et la base d'un transistor Q5 en parallèle sur la charge de la deuxième branche.

Selon la tension présente sur la sortie P de l'amplificateur AD, le gain des amplificateurs A1 e A2 est modifié, puisque leur charge est modifiée.

On remarquera enfin sur la figure 4 que la polarisation des transistors de charge Q6 et Q7 de A2 et Q28 et Q29 de A1 est fixée par trois transistors en série Q8, Q9, Q10 montés en diode (collecteur et base réunis).

Dans un exemple d'application où l'invention s 'avère particulièrement intéressante, le courant Ic est produit par une cellule de transistors montés de telle manière que le courant consommé par la cellule soit directement proportionnel à la température absolue de la cellule. On sait faire de telles cellules, étant donné que les caractéristiques de courant et tension des transistors dépendent d'une manière connue de la température absolue. On a ainsi un moyen particulièrement efficace pour réaliser un étage d'amplification dont le gain est exactement proportionnel à la température absolue.

## Revendications

1. Circuit d'amplification à gain commandé par un signal électrique de consigne, caractérisé en ce qu'il comporte deux amplificateurs à gain commandé identiques (A1 et A2), le premier (A1) recevant un signal à amplifier et fournissant un signal de sortie amplifié, le deuxième (A2) recevant une tension ou un courant de référence, des moyens de comparaison et d'asservissement étant prévus pour comparer la sortie du deuxième amplificateur à un signal de consigne de variation de gain, et pour commander le gain du deuxième amplificateur pour ajuster sa sortie à une valeur désirée, le gain du premier amplificateur étant de plus commandé par le même signal de commande de variation de gain que le deuxième.

2. Circuit d'amplification selon la revendication 1, caractérisé en ce que les deux amplificateurs à gain commandé sont réalisés sur un même substrat de circuit-intégré.

3. Circuit d'amplification selon l'une des revendications 1 et 2, caractérisé en ce que les deux amplificateurs possèdent chacun une entrée de commande de gain recevant un même signal (Vg) provenant de la sortie d'un amplificateur différentiel (AD) dont les entrées reçoivent respectivement d'une part la sortie du deuxième amplificateur à gain commandé (A2) et d'autre part le signal de consigne de gain (Vc).

4. Circuit d'amplification selon l'une des revendications 1 à 3, caractérisé en ce que le signal de consigne de gain est une tension .

5. Circuit d'amplification selon l'une des revendications 1 à 3, caractérisé en ce que le signal de consigne de gain est un courant.

6. Circuit d'amplification selon l'une des revendications 1 à 3, caractérisé en ce que le signal électrique de consigne de gain est appliqué à travers un circuit de calibration à gain réglable (AC).

7. Circuit d'amplification selon la revendication 3, caractérisé en ce que les amplificateurs à gain commandé sont des amplificateurs à deux sorties différentielles, chacune des deux sorties du second amplificateur (A2) étant reliée à travers une résistance respective (R1, R2) à une entrée respective de l'amplificateur différentiel (AD) et l'une des entrées de l'amplificateur différentiel étant en outre reliée à une source de courant de consigne (Ic).

8. Circuit d'amplification selon l'une des revendications 1 à 7, caractérisé en ce que le signal de consigne de gain est un courant ou une tension fonction de la température.

9. Circuit d'amplification selon la revendication 8, caractérisé en ce que le courant ou la tension de consigne est proportionnel à la température absolue.

## Patentansprüche

1. Verstärkungsschaltung mit über ein elektrisches Sollsignal steuerbarem Verstärkungsgrad, dadurch gekennzeichnet, daß sie zwei identische Verstärker (A1, A2) mit steuerbarem Verstärkungsgrad besitzt, von denen der erste (A1) ein zu verstärkendes Signal empfängt und ein verstärktes Ausgangssignal liefert, während der zweite (A2) eine Bezugsspannung oder einen Bezugsstrom empfängt, wobei Vergleichs- und Nachregelmittel vorgesehen sind, um die Ausgangsspannung des zweiten Verstärkers mit einem Sollsignal für die Veränderung des Verstärkungsgrads zu vergleichen und um den Verstärkungsgrad des zweiten Verstärkers so zu steuern, daß sein Ausgang auf einen gewünschten Wert eingestellt wird, und daß der Verstärkungsgrad des ersten Verstärkers außerdem durch dasselbe Steuersignal zur Veränderung des Verstärkungsgrads wie der zweite Verstärker gesteuert wird.

2. Verstärkungsschaltung nach Anspruch 1, dadurch gekennzeichnet, daß die beiden Verstärker mit steuerbarem Verstärkungsgrad auf einem gemeinsamen Substrat als integrierte Schaltung realisiert sind.

3. Verstärkungsschaltung nach einem der Ansprüche 1 und 2, dadurch gekennzeichnet, daß die beiden Verstärker je einen Verstärkungs-Steuereingang besitzen und ein gleiches vom Ausgang eines Differentialverstärkers (AD) kommendes Signal (Vg) empfangen, wobei einer der Eingänge des Differentialverstärkers das Ausgangssignal des zweiten Verstärkers (A2) mit steuerbarem Verstärkungsgrad und der andere das Verstärkungs-Sollsignal (Vc) empfängt.

4. Verstärkungsschaltung nach einem der Ansprüche 1 bis 3, dadurch gekennzeichnet, daß das Verstärkungsgrad-Sollsignal eine Spannung ist.

5. Verstärkungsschaltung nach einem der Ansprüche 1 bis 3, dadurch gekennzeichnet, daß das Verstärkungsgrad-Sollsignal ein Strom ist.

6. Verstärkungsschaltung nach einem der Ansprüche 1 bis 3, dadurch gekennzeichnet, daß das elektrische Verstärkungsgrad-Sollsignal über eine Kalibrierschaltung (AC) mit regelbarem Verstärkungsgrad angelegt wird.

7. Verstärkungsschaltung nach Anspruch 3, dadurch gekennzeichnet, daß die Verstärker mit steuerbarem Verstärkungsgrad Verstärker mit zwei Differentialausgängen sind, wobei jeder der beiden Ausgänge des zweiten Verstärkers (A2) über einen Widerstand (R1, R2) an je einen Eingang des Differentialverstärkers (AD) angeschlossen ist und einer der Eingänge des Differentialverstärkers außerdem an eine Quelle für den Sollstrom (Ic) angeschlossen ist.

8. Verstärkungsschaltung nach einem der Ansprüche 1 bis 7, dadurch gekennzeichnet, daß das Verstärkungsgrad-Sollsignal ein Strom oder eine Spannung eines von der Temperatur abhängigen Werts ist.

9. Verstärkungsschaltung nach Anspruch 8, dadurch gekennzeichnet, daß der Wert des Sollstroms oder der Sollspannung proportional zur absoluten Temperatur ist.

## Claims

1. Amplification circuit with gain controlled by a datum electrical signal, characterized in that it includes two identical, controlled-gain amplifiers (A1 and A2), the first (A1) receiving a signal to be amplified and supplying an amplified output signal, the second (A2) receiving a reference current or voltage, comparison and slaving means being provided for comparing the output of the second amplifier with a gain-variation datum signal, and for controlling the gain of the second amplifier in order to adjust its output to a desired value, the gain of the first amplifier moreover being controlled by the same gain-variation control signal as the second one.

2. Amplification circuit according to Claim 1, characterized in that the two controlled-gain amplifiers are produced on a single integrated-circuit substrate.

3. Amplification circuit according to one of Claims 1 and 2, characterized in that the two amplifiers each possess a gain-control input receiving the same signal (Vg) originating from the output of a differential amplifier (AD), the inputs of which respectively receive, on the one hand, the output of the second controlled-gain amplifer (A2) and, on the other hand, the gain datum signal (Vc).

4. Amplification circuit according to one of Claims 1 to 3, characterized in that the gain datum signal is a voltage.

5. Amplification circuit according to one of Claims 1 to 3, characterized in that the gain datum signal is a current.

6. Amplification circuit according to one of Claims 1 to 3, characterized in that the electrical gain-datum signal is applied through an adjustable-gain calibration circuit (AC).

7. Amplification circuit according to Claim 3, characterized in that the controlled-gain amplifiers are amplifiers with two differential outputs, each of the two outputs of the second amplifier (A2) being linked through a respective resistor (R1, R2) to a respective input of the differential amplifier (AD), and one of the inputs of the differential amplifier furthermore being linked to a datum current source (Ic).

8. Amplification circuit according to one of Claims 1 to 7, characterized in that the gain datum signal is a current or a voltage which is a function of temperature.

9. Amplification circuit according to Claim 8, characterized in that the datum voltage or current is proportional to absolute temperature.
